# FASCICULE DE BREVET EUROPEEN

(11) **EP 1 295 378 B1**
(45) Date de publication et mention de la délivrance du brevet: **25.08.2004**
(21) Numéro de dépôt: 01919605.4
(22) Date de dépôt: 30.03.2001
(51) Int. Cl.: H02K 11/02, H03H 1/00

(54) **DISPOSITIF DE FILTRAGE ET D'ANTIPARASITAGE D'UN MOTEUR ELECTRIQUE**
FILTER UND ENTSTÖRUNGSANORDNUNG FÜR EINEN ELEKTRISCHEN MOTOR
FILTERING AND INTERFERENCE SUPPRESSING DEVICE FOR AN ELECTRIC MOTOR

(30) Priorité: 30.03.2000 FR 0004022
(43) Date de publication de la demande: 26.03.2003
(73) Titulaire: VALEO SYSTEMES D'ESSUYAGE, 78321 La Verrière (FR)
(72) Inventeur: DE DARAN, François, F-75011 PARIS (FR); BRUNEAU, Séverin, F-86100 Chatellerault (FR); ROUYER, Philippe, F-86100 Chatellerault (FR); SALEMBERE, Abdou, F-86100 Châtellerault (FR)
(86) Numéro de dépôt international: PCT/FR2001/000969
(87) Numéro de publication internationale: WO 2001/076042

(56) Documents cités:
- GB-A- 2 217 136
- US-A- 4 329 605
- US-A- 5 420 553
- US-A- 6 018 448

## Description

L'invention concerne un dispositif de filtrage et d'anti-parasitage d'un moteur électrique.

L'invention concerne plus particulièrement un dispositif de filtrage et d'antiparasitage, notamment du type à bande large, à hautes fréquences d'un moteur électrique alimenté par une tension pouvant atteindre au moins 60 Volts.

Les moteurs électriques à balais et collecteur, notamment pour l'entraînement d'équipements tels que par exemple des essuie-glaces ou un dispositif de climatisation, provoquent des parasites dans de larges bandes de fréquences. Ces parasites peuvent perturber le matériel électronique situé à proximité.

En effet, ils peuvent par exemple provoquer la mise en fonctionnement intempestive d'un actionneur commandé par un système électronique.

L'évolution du matériel électronique permet la réalisation de circuits électroniques de plus en plus performants et de moins en moins encombrants, mais ils restent sensibles aux parasites, notamment aux hautes fréquences. Pour résoudre ces problèmes, il existe des dispositifs d'antiparasitage qui réduisent à un faible niveau, ou suppriment, les effets nuisibles des parasites.

Les dispositifs connus consistent principalement en des filtres qui sont constitués par un condensateur dont une borne est reliée à une piste conductrice d'alimentation électrique d'un balai et dont l'autre borne est reliée à la masse électrique du moteur, et par une bobine ou self qui est interposée entre le balai correspondant et la borne du condensateur reliée à la piste conductrice d'alimentation du balai. De manière générale, la bobine supprime les parasites dans les hautes fréquences, alors que le condensateur supprime les parasites dans les basses fréquences.

De tels dispositifs permettent de supprimer les parasites émis dans une gamme de fréquences s'étendant de 150kHz à 100MHz environ. Cependant, l'utilisation de moteurs électriques requiert de plus en plus fréquemment une suppression du rayonnement des parasites dans une gamme de fréquences s'étendant jusqu'à plusieurs GHz.

Pour fournir une solution à ce problème, l'invention propose un dispositif de filtrage et d'antiparasitage d'un moteur électrique comportant au moins un premier balai d'alimentation du collecteur d'induit du moteur électrique, du type qui comporte un condensateur dont une borne est reliée électriquement à une piste conductrice d'alimentation électrique du premier balai d'alimentation du collecteur d'induit du moteur électrique, et dont l'autre borne est reliée électriquement à une piste conductrice de masse reliée à la masse électrique du moteur, caractérisé en ce que le condensateur du dispositif de filtrage et d'antiparasitage est du type non inductif, et en ce que chacun des condensateurs du type non inductif est fixé directement sur une plaque à circuits comportant des pistes conductrices parmi lesquelles au moins une piste conductrice d'alimentation d'un balai et une piste conductrice de masse.

Ainsi, les dispositifs de filtrage et de antiparasitage du type de ceux connus dans l'état de la technique par le dispositif de filtrage et de antiparasitage selon l'invention qui présente des performances améliorées dans un encombrement identique. Il est ainsi possible de conserver un agencement similaire et le même volume du moteur.

Selon d'autres caractéristiques de l'invention :
- le dispositif comporte au moins un premier et un deuxième balai d'alimentation du collecteur d'induit dont chacun est relié à la masse électrique du moteur avec interposition d'un condensateur dont une borne est reliée à une piste conductrice d'alimentation électrique du balai correspondant et dont l'autre borne est reliée à la masse, et en ce que chaque condensateur est un condensateur du type non inductif;
- les deux condensateurs de filtrage et d'antiparasitage du type non inductif sont réalisés sous la forme d'un condensateur du type non inductif double ;
- la plaque à circuit est la plaque porte-balais du moteur électrique ;
- chaque condensateur de filtrage et d'antiparasitage est du type CMS ;
- les bornes électriques de chaque condensateur du type non inductif sont reliées électriquement et fixées directement sur les pistes conductrices correspondantes ;
- chaque borne est fixée et est reliée électriquement à la piste correspondante par soudage ;
- chaque borne est fixée et est reliée électriquement à la piste correspondante par collage au moyen d'une colle conductrice ;
- le dispositif comporte au moins un autre condensateur interposé entre la piste de masse et une portion de la piste d'alimentation de l'un au moins des balais d'alimentation du collecteur qui est située entre le condensateur de type non inductif et le balai correspondant ;
- l'un au moins des autres condensateurs est du type CMS;
- la portion de l'une au moins des pistes d'alimentation de l'un des balais d'alimentation du collecteur, qui est située entre le condensateur du type non inductif et le balai correspondant, comporte une self en série ;
- le dispositif comporte une self interposée, sur la piste de masse, en série entre une borne de masse du condensateur du type non inductif et le balai ;
- l'une au moins des selfs est du type à haute fréquence;
- l'une au moins des selfs est bobinée et en ce qu'elle comporte au moins un espace qui sépare deux spires juxtaposées;
- l'une au moins des selfs est du type CMS ;
- il comporte une protection thermique située sur la piste de masse ;
- le dispositif comporte au moins un écrêteur qui est monté en parallèle avec le condensateur de type non inductif, entre la piste de masse et l'une des pistes conductrices ;
- l'un au moins des écrêteurs est du type CMS.

D'autres avantages de l'invention apparaîtront à la lecture de la description détaillée qui suit pour la compréhension de laquelle on se reportera aux dessins annexés dans lesquels :
- la figure 1 représente une plaque porte-balais d'extrémité axiale d'un moteur électrique portant les balais d'alimentation d'un collecteur d'induit ;
- la figure 2 représente, de façon schématique, un circuit de commande d'un moteur électrique comportant un dispositif de filtrage et d'antiparasitage selon l'état de la technique ;
- la figure 3 représente, de façon schématique, un dispositif de filtrage et d'antiparasitage d'un moteur électrique réalisé conformément aux enseignements de l'invention ;
- la figure 4 est une vue en perspective éclatée d'un condensateur du type non inductif avant son montage sur la plaque porte-balais du moteur électrique ;
- les figures 5 à 7 sont des représentations schématiques similaires à celle représentée de la figure 3 selon deux variantes de réalisation de l'invention.

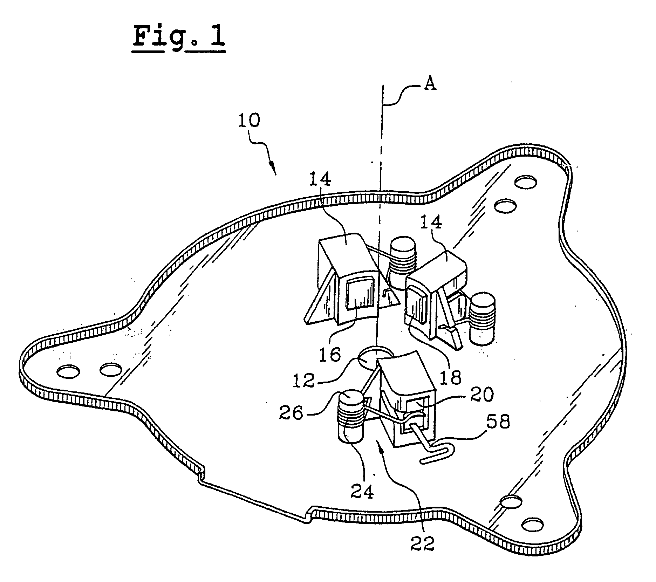

On a représenté sur la figure 1 une plaque porte-balais 10, ou flasque, destinée à constituer le capot ou palier de fermeture axiale d'un moteur électrique dont les autres composants, notamment la carcasse ou chemise statorique et le rotor d'induit ne sont pas représentés.

La plaque porte-balais 10 comporte une ouverture circulaire 12 centrale, d'axe A, qui reçoit un palier, non représenté qui permet le guidage en rotation d'une extrémité libre du rotor d'induit.

Trois logements 14 reçoivent ici chacun un balai 16, 18 et 20.

Chaque logement 14 est complémentaire du balai 16, 18 ou 20 qu'il reçoit, et est débouchant radialement à ses extrémités radiales opposées, intérieure et extérieure par rapport à l'axe A.

Chaque balai 16, 18 et 20 est, de manière connue, sollicité élastiquement en permanence radialement vers l'intérieur, par un ressort de balai 22 dont le corps hélicoïdal 24 est monté enfilé axialement sur un doigt de montage 26.

Chaque balai 16, 18 et 20 est relié électriquement à une piste électrique conductrice 38, 40 et 58 respectivement.

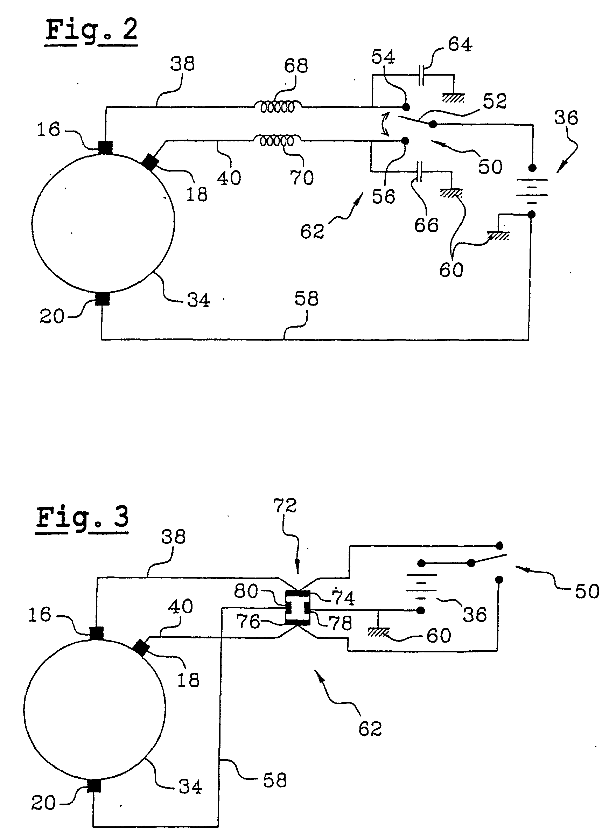

Un moteur électrique 34 du type décrit précédemment est représenté schématiquement à la figure 2.

Le moteur 34 est à courant continu à deux vitesses. Il comporte un premier balai 16 de polarité positive pour la vitesse lente, un second balai 18 de polarité positive pour la vitesse rapide et un balai 20 de polarité négative, qui permettent l'alimentation électrique du collecteur d'induit (non représenté) du moteur 34.

Les balais 16, 18 et 20 sont alimentés électriquement par une source d'alimentation 36, telle que la batterie d'accumulateurs du véhicule.

Des pistes conductrices 38 et 40 d'alimentation électrique alimentent le premier et le second balais 16, 18 respectivement à partir de la borne positive de la source d'alimentation 36.

Il est prévu un commutateur électrique 50 du type unipolaire à deux positions extrêmes et une position centrale qui correspond à l'arrêt du moteur 34.

Le commutateur 50 comporte un contact mobile 52 et deux contacts fixes 54 et 56 reliés aux extrémités des pistes conductrices 38 et 40 respectivement. Les deux positions extrêmes du commutateur 50 correspondent ainsi aux positions dans lesquelles le contact mobile 52 est en contact avec le contact fixe 54 ou 56 de façon à alimenter le premier balai 16 pour la vitesse lente ou le second balai 18 pour la vitesse rapide respectivement.

Une piste conductrice 58 relie électriquement le balai 20 de polarité négative à la borne négative de la source d'alimentation 36. La piste conductrice 58 est ici reliée à la masse électrique 60 du moteur électrique 34, conformément à la figure 2. La piste conductrice 58 est alors appelée piste conductrice de masse 58.

La connexion de la piste conductrice 50 et de la masse électrique 60 peut être réalisée en amont ou en aval du condensateur 72 de type non inductif, par rapport à la source d'alimentation 36.

Conformément à l'état de technique, un dispositif de filtrage et d'antiparasitage 62 est constitué de deux couples formé chacun d'un condensateur 64, 66, et d'une self 68, 70 ou bobine et dont chacun est associé à la piste conductrice d'alimentation du premier ou du second balai 16, 18 respectivement.

Les condensateurs 64 et 66 sont interposés entre la masse électrique 60 du moteur 34 et la piste d'alimentation 38 et 40 respectivement.

Les selfs 68 et 70 sont montées en série sur les pistes conductrices 38 et 40 entre les balais 16 et 18 et les bornes des condensateurs 64 et 66 qui sont reliées aux pistes conductrices 38 et 40 respectivement.

Un tel dispositif de filtrage et d'antiparasitage 62 ne permet de supprimer les émissions de parasites que dans une gamme de fréquences s'étendant de 150kHz à 100MHz environ, en fonction des performances et caractéristiques de ces composants discrets.

L'invention permet d'étendre cette gamme de fréquences jusqu'à plusieurs GHz.

Pour ce faire, les condensateurs 64 et 66 et les selfs 68 et 70 sont remplacés par un condensateur 72 de type non inductif double. Un tel condensateur type de non inductif est par exemple fabriqué par la société SYFER et par exemple commercialisé sous la référence 1410J05000404MXBE03.

La figure 3 illustre schématiquement le circuit de commande selon l'invention du moteur électrique 34.

Le condensateur 72 de type non inductif comporte quatre bornes de contact, de façon à réaliser un composant symétrique, deux d'entre elles 74 et 76 étant reliées aux pistes conductrices d'alimentation 38 et 40 respectivement, les deux autres 78 et 80, dites de masse, étant reliées à la masse électrique 60. Avantageusement, les deux bornes 78 et 80 peuvent être réunies en une borne unique de masse.

Le condensateur 72 de type non inductif est du type CMS, c'est-à-dire que c'est un composant à montage en surface. Il ne possède pas de pattes de raccordement électrique, ses bornes de contact 74 à 80 étant reliées électriquement, et fixées, directement sur les pistes conductrices correspondantes.

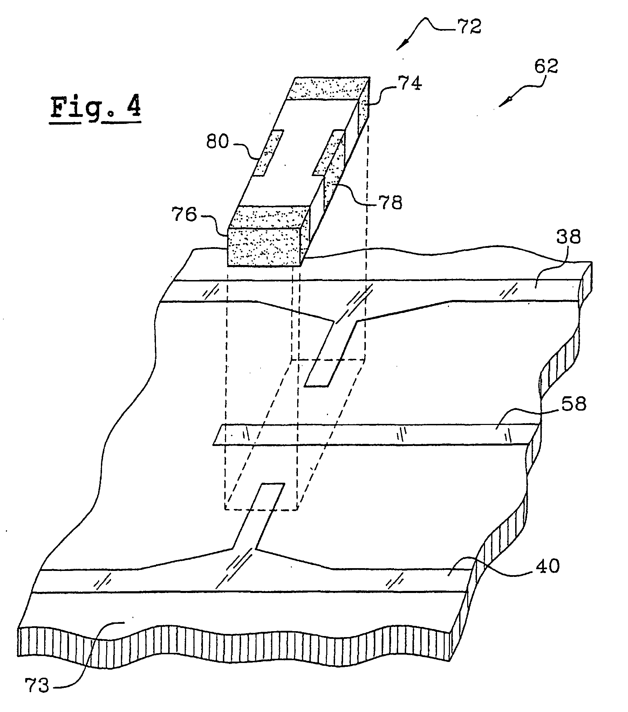

La figure 4 illustre un tel condensateur 72 avant son montage sur les pistes conductrices d'une la plaque à circuits 73.

Avantageusement, la plaque à circuits 73 est la plaque porte-balais 10 du moteur électrique 34.

Les pistes conductrices 38, 40 et 58 sont ici sérigraphiées ou découpées et rapportées sur la plaque porte-balais 10. Lors de l'assemblage du condensateur 72 du type non inductif, les bornes 74, 76, 78 et 80 sont fixées et reliées électriquement aux pistes conductrices correspondantes 38, 40 ou 58 par un procédé tel que le soudage (soudures et brasage), le sertissage, le clipsage ou le collage au moyen d'une colle conductrice.

Le condensateur 72 de type non inductif permet ainsi de diminuer le nombre de composants constituant le dispositif de filtrage et d'antiparasitage 62, mais aussi d'améliorer les performances de ce dernier.

Ainsi, par exemple, pour un moteur électrique 34 d'entraînement des essuie-glaces d'un véhicule automobile alimenté par une tension électrique pouvant aller au moins jusqu'à 60 Volts, il est intéressant d'utiliser un condensateur 72 de type non inductif d'une capacité de 1µF pour supprimer l'émission de parasites dans une bande de fréquences s'étendant de 150 kHz à quelques GHz.

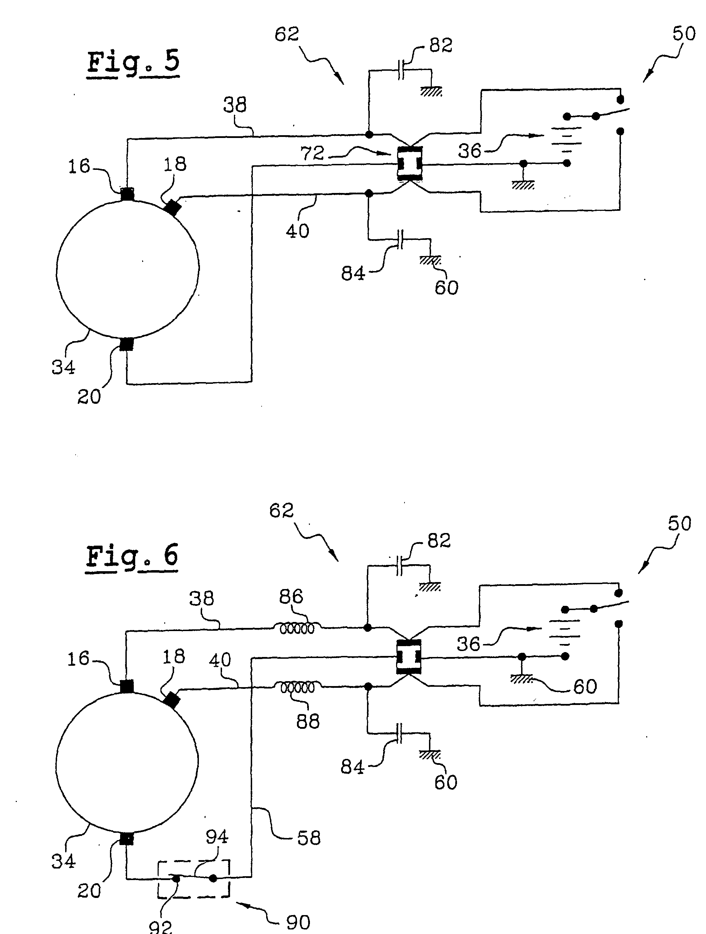

Une première variante de réalisation de l'invention propose, conformément à la figure 5, d'interposer deux condensateurs 82 et 84 entre la masse électrique 60 du moteur 34 et les portions de la piste d'alimentation 38 et 40 situées entre les balais 16 et 18 et le condensateur 72 du type inductif respectivement.

Ainsi, la mise en oeuvre d'un condensateur 72 de type non inductif d'une capacité de 100nF avec deux condensateurs 82 et 84 d'une capacité de 1µF permet d'obtenir des résultats similaires au montage précédent.

La figure 6 propose une seconde variante qui permet d'augmenter la précision des résultats obtenus par le dispositif de filtrage et d'antiparasitage 62 en ajoutant en série une self 86, 88 sur la portion de la piste d'alimentation 38, 40 du balai 16, 20 d'alimentation du collecteur qui est située entre le condensateur de type non inductif 72 et le balai 16, 18 correspondant.

Avantageusement, un dispositif de protection thermique 90 monté sur la piste de masse 58 permet d'arrêter le moteur 34 lorsque la température à laquelle il est soumis dépasse une température limite qui risque d'endommager le moteur 34.

Le dispositif de protection thermique 90 consiste, par exemple, en un bilames qui comporte une première lame fixe 92 et une seconde lame articulée 94. Lorsque la température du bilames est inférieure à la température limite, les deux lames 92 et 94 sont en contact, conformément à la figure 6. Lorsque la température du bilames devient supérieure à la température limite, la dilatation de la lame 94 provoque sa rotation autour de son articulation et s'écarte de la lame 92, de façon à ouvrir le circuit, et couper l'alimentation du balai 20.

Selon une autre variante, non représentée, la piste de masse 58 n'est pas connectée directement à la masse électrique 60 du moteur électrique 34. Dans ce cas, un condensateur du type inductif ou non inductif relie la piste de masse 58 à la masse électrique 60 du moteur 34.

Une self peut aussi être interposée en série, sur la piste de masse 58, entre une borne de masse 78, 80 du condensateur 72 du type non inductif et le balai 20. Permettant ainsi d'augmenter encore les performances du dispositif de filtrage et d'antiparasitage 62.

La self peut être du type à bande large. Elle peut être bobinée et comporter un espace entre chaque spire juxtaposée, une telle self est appelée self à spires non jointives.

Des dispositifs écrêteurs, non représentés, qui permettent d'éviter les surtensions au niveau des balais 16 et 18, et dont chacun peut avantageusement être monté en parallèle avec le condensateur 72 entre la piste de masse 58 et l'une des pistes conductrices 38 et 40. Ces dispositifs écrêteurs peuvent être composés de varistances ou de composants silicium du type diode Zener.

Les dispositifs écrêteurs peuvent être fixés sur leur support par des pattes de montage ou peuvent être du type à montage de surface CMS.

Avantageusement, tous les composants du dispositif de filtrage et d'antiparasitage 62 selon l'invention, notamment les condensateurs 82, 84, les selfs 86, 88 et la protection thermique peuvent être remplacés par des composants du type à montage de surface CMS.

## Revendications

1. Dispositif de filtrage et d'antiparasitage (62), notamment du type à bande large, d'un moteur électrique (34) comportant au moins un premier balai (16) d'alimentation du collecteur d'induit du moteur électrique (34), du type qui comporte un condensateur (64) dont une borne est reliée électriquement à une piste conductrice (38) d'alimentation électrique du premier balai (16) d'alimentation du collecteur d'induit du moteur électrique (34), et dont l'autre borne est reliée électriquement à une piste conductrice de masse (58) reliée à la masse électrique (60) du moteur électrique (34), **caractérisé en ce que** le condensateur (72) du dispositif de filtrage et d'antiparasitage (62) est du type non inductif, et **en ce que** chacun des condensateurs (72) du type non inductif est fixé directement sur une plaque à circuits (73) comportant des pistes conductrices parmi lesquelles au moins une piste conductrice d'alimentation (38, 40) d'un balai et une piste conductrice de masse (58).

2. Dispositif de filtrage et d'antiparasitage (62) d'un moteur électrique (34) selon la revendication précédente, **caractérisé en ce qu'**il comporte au moins un premier (16) et un deuxième balai (18) d'alimentation du collecteur d'induit dont chacun est relié à la masse électrique (60) du moteur (34) avec interposition d'un condensateur (72) dont une borne (74, 76) est reliée à une piste conductrice (38, 40) d'alimentation électrique du balai (16, 18) correspondant et dont l'autre borne (78, 80) de masse est reliée à la masse (60), et **en ce que** chaque condensateur (72) est un condensateur (72) du type non inductif.

3. Dispositif de filtrage et d'antiparasitage (62) selon la revendication précédente, **caractérisé en ce que** les deux condensateurs (72) de filtrage et d'antiparasitage du type non inductif sont réalisés sous la forme d'un condensateur du type non inductif double (72).

4. Dispositif de filtrage et d'antiparasitage (62) selon l'une quelconque des revendications précédentes, **caractérisé en ce que** la plaque à circuits (73) est la plaque porte-balais (10) du moteur électrique (34).

5. Dispositif de filtrage et d'antiparasitage (62) selon l'une quelconque des revendications précédentes, **caractérisé en ce que** chaque condensateur (72) de filtrage et d'antiparasitage du type non inductif est du type CMS.

6. Dispositif de filtrage et d'antiparasitage (62) selon l'une quelconque des revendications précédentes, **caractérisé en ce que** les bornes (74, 76, 78 ,80) électriques de chaque condensateur (72) du type non inductif sont reliées électriquement et fixées directement sur les pistes conductrices (38, 40, 58) correspondantes.

7. Dispositif de filtrage et d'antiparasitage (62) selon la revendication précédente, **caractérisé en ce que** chaque borne (74, 76, 78 ,80) est fixée et est reliée électriquement à la piste correspondante par soudage.

8. Dispositif de filtrage et d'antiparasitage (62) selon l'une des revendications 6 ou 7, **caractérisé en ce que** chaque borne (74, 76, 78, 80) est fixée et est reliée électriquement à la piste (38, 40, 58) correspondante par collage au moyen d'une colle conductrice.

9. Dispositif de filtrage et d'antiparasitage (62) selon l'une quelconque des revendications précédentes, **caractérisé en ce qu'**il comporte au moins un autre condensateur (82, 84) interposé entre la piste de masse (58) et une portion de la piste (38, 40) d'alimentation de l'un au moins des balais (16, 18) d'alimentation du collecteur d'induit du moteur électrique (34) qui est située entre le condensateur (72) de type non inductif et le balai (16, 18) correspondant.

10. Dispositif de filtrage et d'antiparasitage (62) selon la revendication précédente, **caractérisé en ce que** l'un au moins des autres condensateurs (82, 84) est du type CMS.

11. Dispositif de filtrage et d'antiparasitage (62) selon l'une quelconque des revendications précédentes, **caractérisé en ce que** la portion de l'une au moins des pistes (38, 40) d'alimentation de l'un des balais (16, 18) d'alimentation du collecteur, qui est située entre le condensateur (72) du type non inductif et le balai (16, 18) correspondant, comporte une self (86, 88) en série.

12. Dispositif de filtrage et d'antiparasitage (62) selon l'une quelconque des revendications précédentes, **caractérisé en ce qu'**il comporte une self interposée, sur la piste de masse (58), en série entre une borne (78, 80) de masse du condensateur (72) du type non inductif et le balai (20).

13. Dispositif de filtrage et d'antiparasitage (62) selon l'une des revendications 11 ou 12, **caractérisé en ce que** l'une au moins des selfs (86, 88) est du type à haute fréquence.

14. Dispositif de filtrage et d'antiparasitage (62) selon l'une quelconque des revendications 11 à 13, **caractérisé en ce que** l'une au moins des selfs (86, 88) est bobinée et **en ce qu'**elle comporte au moins un espace qui sépare deux spires juxtaposées.

15. Dispositif de filtrage et d'antiparasitage (62) selon l'une quelconque des revendications 11 à 14, **caractérisé en ce que** l'une au moins des selfs (86, 88) est du type CMS.

16. Dispositif de filtrage et d'antiparasitage (62) selon l'une quelconque des revendications précédentes, **caractérisé en ce qu'**il comporte une protection thermique (90) située sur la piste de masse (58).

17. Dispositif de filtrage et d'antiparasitage (62) selon l'une quelconque des revendications 9 à 16, **caractérisé en ce qu'**il comporte au moins un écrêteur qui est monté en parallèle avec le condensateur (72) de type non inductif, entre la piste de masse (58) et l'une des pistes conductrices (38, 40).

18. Dispositif de filtrage et de antiparasitage (62) selon la revendication précédente, **caractérisé en ce que** l'un au moins des écrêteurs est du type CMS.

## Patentansprüche

1. Filter- und Entstörungsvorrichtung (62), insbesondere von Typ Breitband, eines Elektromotors (34) mit wenigstens einem ersten Abtaster (16) zur Versorgung des Sekundärstromkollektors des Elektromotors (34), von dem Typ, der einen Kondensator (64) umfasst, dessen eine Anschlussklemme elektrisch an eine Leiterbahn (38) zur elektrischen Versorgung des ersten Abtasters (16) des Sekundärstromkollektors des Elektromotors (34) angeschlossen ist und dessen andere Anschlussklemme elektrisch an eine an die elektrische Masse (60) des Elektromotors (34) angeschlossene Massen-Leiterbahn (58) angeschlossen ist, **dadurch gekennzeichnet, dass** der Kondensator (72) der Filter- und Entstörungsvorrichtung (62) vom nicht induktiven Typ ist und dass jeder Kondensator (72) vom nicht induktiven Typ direkt auf einer Leiterbahnen umfassenden Flachbaugruppe (73) befestigt ist, davon wenigstens eine Versorgungsleiterbahn (38, 40) eines Abtasters und eine Massen-Leiterbahn (58).

2. Filter- und Entstörungsvorrichtung (62) eines Elektromotors (34) gemäß dem vorhergehenden Anspruch, **dadurch gekennzeichnet, dass** sie wenigstens einen ersten (16) und einen zweiten (18) Abtaster zur Versorgung des Sekundärstromkollektors umfasst, von denen jeder an die elektrischen Masse (60) des Motors (34) unter Zwischenschaltung eines Kondensators (72) angeschlossen ist, dessen eine Anschlussklemme (74, 76) an eine Leiterbahn (38, 40) zur elektrischen Versorgung des entsprechenden Abtasters (18, 18) angeschlossen ist und dessen andere Anschlussklemme (78, 80) der Masse an die Masse (60) angeschlossen ist und dass jeder Kondensator (72) ein Kondensator (72) vom nicht induktiven Typ ist.

3. Filter- und Entstörungsvorrichtung (62) gemäß dem vorherigen Anspruch, **dadurch gekennzeichnet, dass** die beiden Filter- und Entstörungskondensatoren (72) vom nicht induktiven Typ in Form eines Kondensators vom nicht induktiven doppelten Typ (72) sind.

4. Filter- und Entstörungsvorrichtung (62) gemäß einem der vorherige Ansprüche, **dadurch gekennzeichnet, dass** die Leiterplatte (73) die Abtaster-Trägerplatte (10) des Elektromotors (34) ist.

5. Filter- und Entstörungsvorrichtung (62) gemäß einem der vorherigen Ansprüche, **dadurch gekennzeichnet, dass** jeder Filter- und Entstörungskondensator (72) vom nicht induktiven Typ vom Typ CMS ist.

6. Filter- und Entstörungsvorrichtung (62) gemäß einem der vorherigen Ansprüche, **dadurch gekennzeichnet, dass** die elektrischen Anschlussklemmen (74, 76, 78, 80) jedes Kondensators (72) vom nicht induktiven Typ direkt auf den entsprechenden Leiterbahnen (38, 40, 58) elektrisch angeschlossen und befestigt sind.

7. Filter- und Entstörungsvorrichtung (62) gemäß dem vorherigen Anspruch, **dadurch gekennzeichnet, dass** jede Anschlussklemme (74, 76, 78, 80) an der entsprechenden Leiterbahn durch Löten befestigt und elektrisch an sie angeschlossen ist.

8. Filter- und Entstörungsvorrichtung (62) gemäß Anspruch 6 oder 7, **dadurch gekennzeichnet, dass** jede Anschlussklemme (74, 76, 78, 80) durch Verkleben mittels eines leitfähigen Klebstoffs,an der entsprechenden Leiterbahn (38, 40, 58) befestigt und elektrisch an sie angeschlossen ist.

9. Filter- und Entstörungsvorrichtung (62) gemäß einem der vorherigen Ansprüche, **dadurch gekennzeichnet, dass** sie wenigstens einen weiteren, zwischen der Massenleiterbahn (58) und einem Abschnitt der Leiterbahn (38, 40) zur Versorgung wenigstens eines der Abtaster (16, 18) zur Versorgung des Sekundärstromkollektors des Elektromotors (34) zwischengeschalteten Kondensator (82, 84) umfasst, welcher sich zwischen dem Kondensator (72) vom nicht induktiven Typ und dem entsprechenden Abtaster (16, 18) befindet.

10. Filter- und Entstörungsvorrichtung (62) gemäß dem vorherigen Anspruch, **dadurch gekennzeichnet, dass** wenigstens einer der weiteren Kondensatoren (82, 84) vom Typ CMS ist.

11. Filter- und Entstörungsvorrichtung (62) gemäß einem der vorherigen Ansprüche, **dadurch gekennzeichnet, dass** der Abschnitt wenigstens einer der Leiterbahnen (38, 40) zur Versorgung einer der Abtaster (16, 18) zur Versorgung des Kollektors, welche sich zwischen dem Kondensator (72) vom nicht induktiven Typ und dem entsprechenden Abtaster (16, 18) befindet, einen in Serie geschalteten Drosselwiderstand (86, 88) umfasst.

12. Filter- und Entstörungsvorrichtung (62) gemäß einem der vorherigen Ansprüche, **dadurch gekennzeichnet, dass** er auf der Massenleiterbahn (58) zwischen einer Massenanschlussklemme (78, 80) des Kondensators (72) vom nicht induktiven Typ und dem Abtaster (20) einen zwischengeschalteten, in Serie geschalteten Drosselwiderstand umfasst.

13. Filter- und Entstörungsvorrichtung (62) gemäß Anspruch 11 oder 12, **dadurch gekennzeichnet, dass** wenigstens einer der Drosselwiderstände (86, 88) vom Hochfrequenztyp ist.

14. Filter- und Entstörungsvorrichtung (62) gemäß Anspruch 11 bis 13, **dadurch gekennzeichnet, dass** wenigstens einer der Drosselwiderstände (86, 88) als Spule aufgewickelt ist und dass er wenigstens einen Raum umfasst, der zwei nebeneinander liegende Wicklungen trennt.

15. Filter- und Entstörungsvorrichtung (62) gemäß Anspruch 11 bis 14, **dadurch gekennzeichnet, dass** wenigstens einer der Drosselwiderstände (86, 88) vom Typ CMS ist.

16. Filter- und Entstörungsvorrichtung (62) gemäß einem der vorherigen Ansprüche, **dadurch gekennzeichnet, dass** er einen Wärmeschutz (90) auf der Massenleiterbahn (58) umfasst.

17. Filter- und Entstörungsvorrichtung (62) gemäß Anspruch 9 bis 16, **dadurch gekennzeichnet, dass** er wenigstens einen Begrenzer umfasst, der zwischen der Massenleiterbahn (58) und einer der Leiterbahnen (38, 40) parallel mit dem Kondensator (72) vom nicht induktiven Typ montiert ist.

18. Filter und Entstörungsvörrichtung (62) gemäß dem vorherigen Anspruch, **dadurch gekennzeichnet, dass** wenigstens einer der Begrenzer vom Typ CMS ist.

## Claims

1. A filtering and interference-suppression device (62), in particular of the broad band type, for an electric motor (34) comprising at least one first supply brush (16) for the armature collector of the electric motor (34), of the type which comprises a capacitor (64), one terminal of which is connected electrically to a conductive electrical supply track (38) for the first supply brush (16) of the armature collector of the electric motor (34) and the other terminal of which is electrically connected to a conductive earth track (58) connected to the electrical earth (60) of the electric motor (34), **characterised in that** the capacitor (72) of the filtering and interference-suppression device (62) is of the non-inductive type, and **in that** each of the capacitors (72) of the non-inductive type is fixed directly to a circuit plate (73) comprising conductive tracks including at least one conductive track (38, 40) supplying a brush and a conductive earth track (58).

2. A filtering and interference-suppression device for an electric motor (34) according to the preceding claim, **characterised in that** it comprises at least a first (16) and second (18) supply brush for the armature collector, each of which is connected to the electrical earth (60) of the motor (34) with the interposing of a capacitor (72) whose terminal (74, 76) is connected to a conductive electrical supply track (38, 40) for the corresponding brush (16, 18) and the other terminal (78, 80) of which is connected to earth (60), and **in that** each capacitor (72) is a capacitor (72) of the non-inductive type.

3. A filtering and interference-suppression device (62) according to the preceding claim, **characterised in that** the two filtering and interference-suppression capacitors (72) of the non-inductive type are produced in the form of a capacitor of the double non-inductive type (72).

4. A filtering and interference-suppression device (62) according to any one of the preceding claims, **characterised in that** the circuit plate (73) is a brush-holder plate (10) of the electric motor (34).

5. A filtering and interference-suppression device (62) according to any one of the preceding claims, **characterised in that** each filtering and interference-suppression capacitor (72) of the non-inductive type is of the CMS type.

6. A filtering and interference-suppression device (62) according to any one of the preceding claims, **characterised in that** the electrical terminals (74, 76, 78, 80) of each capacitor (72) of the non-inductive type are electrically connected and fixed directly to the corresponding conductive tracks (38, 40, 58).

7. A filtering and interference-suppression device (62) according to the preceding claim, **characterised in that** each terminal (74, 76, 78, 80) is fixed and electrically connected to the corresponding track by soldering.

8. A filtering and interference-suppression device (62) according to one of Claims 6 or 7, **characterised in that** each terminal (74, 76, 78, 80) is fixed and electrically connected to the corresponding track (38, 40, 58) by bonding by means of a conductive adhesive.

9. A filtering and interference-suppression device (62) according to any one of the preceding claims, **characterised in that** it comprises at least one other capacitor (82, 84) interposed between the earth track (58) and a portion of the supply track (38, 40) of at least one of the supply brushes (16, 18) of the armature collector (34) which is situated between the capacitor (72) of the non-inductive type and the corresponding brush (16, 18).

10. A filtering and interference-suppression device (62) according to the preceding claim, **characterised in that** at least one of the other capacitors (82, 84) is of the CMS type.

11. A filtering and interference-suppression device (62) according to any one of the preceding claims, **characterised in that** the portion of at least one of the supply tracks (38, 40) of one of the collector supply brushes (16, 18), which is situated between the capacitor (72) of the non-inductive type and the corresponding brush (16, 18), comprises a choke (86, 88) in series.

12. A filtering and interference-suppression device (62) according to any one of the preceding claims, **characterised in that** it comprises a choke interposed, on the earth track (58), in series between an earth terminal (78, 80) of the capacitor (72) of the non-inductive type and the brush (20).

13. A filtering and interference-suppression device (62) according to one of Claims 11 or 12, **characterised in that** at least one of the chokes (86, 88) is of the high-frequency type.

14. A filtering and interference-suppression device (62) according to any one of Claims 11 to 13, **characterised in that** at least one of the chokes (86, 88) is wound and comprises at least one space which separates two juxtaposed turns.

15. A filtering and interference-suppression device (62) according to any one of Claims 11 to 14, **characterised in that** at least one of the chokes (86, 88) is of the CMS type.

16. A filtering and interference-suppression device (62) according to any one of the preceding claims, **characterised in that** it comprises thermal protection (90) situated on the earth track (58).

17. A filtering and interference-suppression device (62) according to any one of Claims 9 to 16, **characterised in that** it comprises at least one clipping circuit which is mounted in parallel with the capacitor (72) of the non-inductive type, between the earth track (58) and one of the conductive tracks (38, 40).

18. A filtering and interference-suppression device (62) according to the preceding claim, **characterised in that** at least one of the clipping circuits is of the CMS type.
